# EUROPÄISCHE PATENTSCHRIFT

(11) **EP 2 118 207 B1**
(45) Veröffentlichungstag und Bekanntmachung des Hinweises auf die Patenterteilung: **23.11.2011**
(21) Anmeldenummer: 08701023.7
(22) Anmeldetag: 09.01.2008
(51) Int. Cl.: C09B 67/48, B41M 1/10

(54) **FEINTEILIGES C.I. PIGMENT YELLOW 181**
FINELY DISPERSED C.I. PIGMENT YELLOW 181
PIGMENT C.I. JAUNE 181 A FINES PARTICULES

(30) Priorität: 07.02.2007 DE 102007005991
(43) Veröffentlichungstag der Anmeldung: 18.11.2009
(73) Patentinhaber: Clariant Finance (BVI) Limited, Road Town, Tortola (VG)
(72) Erfinder: PLÜG, Carsten, 64367 Mühltal/Niederbeerbach (DE); WEBER, Joachim, 4153 Reinach (CH); BONER, Harald, 65843 Sulzbach (DE); ALFTER, Frank, 65812 Bad Soden (DE); SHIM, HaeJin, Ulsan 680-190 (KR)
(74) Vertreter: Hütter, Klaus
(86) Internationale Anmeldenummer: PCT/EP2008/000085
(87) Internationale Veröffentlichungsnummer: WO 2008/095573

(56) Entgegenhaltungen:
- WO-A-2006/005408
- WO-A-2006/119846
- US-A1- 2006 256 175
- STENGEL-RUTKOWSKI B ET AL: "Gelb und wetterecht: Ein neues Monoazopigment" 20001231, Bd. 106, 31. Dezember 2000 (2000-12-31), Seiten 38-42, XP008070637

## Beschreibung

Die vorliegende Erfindung betrifft ein neues, feinteiliges und lichtechtes C.I. Pigment Yellow 181.

Zur Herstellung hochtransparenter dauerhafter Färbungen werden besonders feinteilige organische Farbpigmente benötigt, um die Partikel-Streuung weitgehend auszuschließen. Gegenüber ebenfalls hochtransparenten Farbstofffärbungen weisen Pigmente eine deutlich bessere Lichtechtheit auf. Die Kombination von Transparenz mit Lichtechtheit ist besonders in den Bereichen Dekordruck, Ink-Jet-Druck und Colorfilter oftmals von entscheidender Bedeutung. Für rotstichige Gelbtöne wird zunehmend C.I. Pigment Yellow 181 der Formel (I) 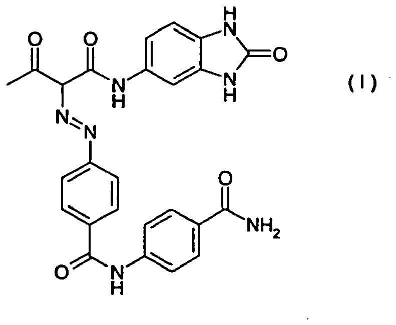 allein oder in Kombination mit anderen Farbmitteln eingesetzt, da es einen reinen Farbton mit hoher Transparenz und mit einer sehr guten Lichtechtheit verbindet.

Die beta-Phase von C.I. Pigment Yellow 181 ist durch die folgenden Linien im Röntgenpulverdiagramm (Cu-K_{α1}-Strahlung, doppelte Beugungswinkel 2Θ in Grad, d-Werte in Å⁻¹ in Grad, Netzebenenabstände d in Å⁻¹) charakterisiert:

| 2Θ d | rel. Intensität | |
|---|---|---|
| 4,15 | 21,3 | 4 |
| 8,30 | 10,6 | 6 |
| 10,92 | 8,1 | 2 |
| 12,50 | 7,1 | 3 |
| 13,99 | 6,3 | 12 |
| 16,75 | 5,3 | 22 |
| 17,54 | 5,1 | 32 |
| 18,38 | 4,8 | 82 |
| 19,19 | 4,6 | 31 |
| 19,48 | 4,6 | 47 |
| 19,75 | 4,5 | 40 |
| 21,90 | 4,1 | 73 |
| 22,19 | 4,0 | 31 |
| 23,12 | 3,8 | 13 |
| 24,52 | 3,6 | 11 |
| 24,94 | 3,6 | 9 |
| 25,35 | 3,5 | 93 |
| 26,74 | 3,3 | 7 |
| 27,75 | 3,2 | 7 |
| 28,43 | 3,1 | 100 |
| 29,96 | 3,0 | 9 |
| 31,87 | 2,8 | 10 |

Die WO 2006/005408 A1 offenbart die Herstellung weiterer Kristallmodifikationen von C.I. Pigment Yellow 181, die allesamt gelbe Farbtöne und gute coloristische Eigenschaften aufweisen. Die technisch bedeutsame beta-Phase wird beispielsweise durch die Behandlung mit Lösungsmitteln gewonnen, wie beispielsweise in EP-A-0 010 273, Beispiel 1 beschrieben.

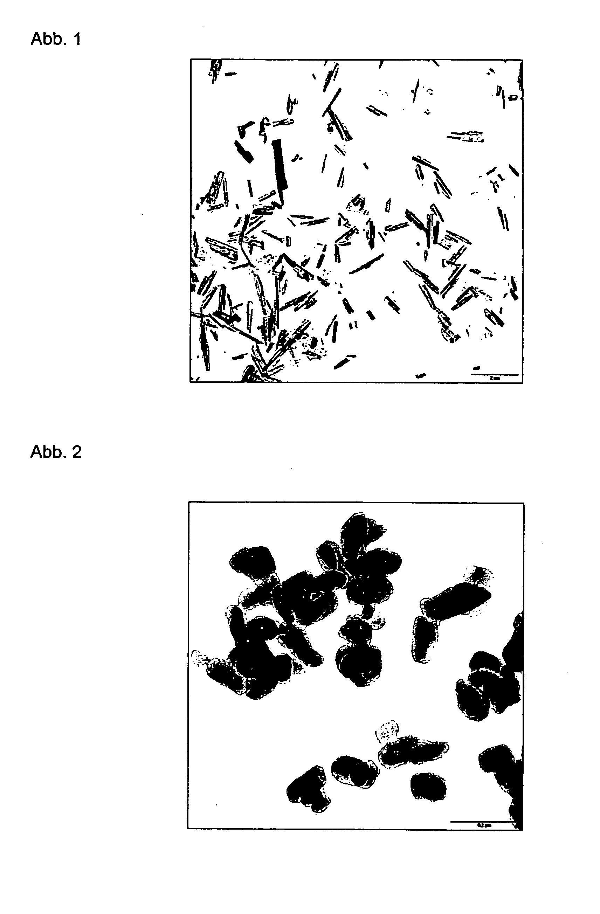

Die beta-Phase liegt nach den bisher bekannten Verfahren immer in Nadelform vor, wobei das Länge-zu-Breite-Verhältnis größer oder gleich 3:1 und die mittlere Teilchengröße d₅₀ größer als 200 nm beträgt. Siehe hierzu Abb. 1.

Die beta-Phase von C.I. Pigment Yellow 181 in ihrer bislang bekannten Ausprägung ist mit Nachteilen verbunden. Durch den nadelförmigen Kristallhabitus sind die Verarbeitungseigenschaften hinsichtlich Fließfähigkeit nicht immer befriedigend. Außerdem ist die Farbstärke und Transparenz von C.I. Pigment Yellow 181 in der beta-Form nicht für alle Anwendungsgebiete ausreichend. Eine Erhöhung der Farbstärke von 20 % wird als signifikant und wünschenswert angesehen.

Es bestand somit die Aufgabe, die beta-Phase von C.I. Pigment Yellow 181 in einer feinteiligen, farbstarken und nicht nadelförmigen Kristallform bereitzustellen, ohne die Lichtechtheit signifikant zu beeinträchtigen.

Es wurde gefunden, dass ein C.I. Pigment Yellow 181 in der beta-Phase mit einer mittleren Teilchengrößenverteilung d₅₀ von 80 bis 120 nm und einem Länge-Breite-Verhältnis von kleiner oder gleich 2:1 überraschenderweise diese Aufgabe löst.

Überraschenderweise zeigen Färbungen eines erfindungsgemäßen C.I. Pigment Yellow 181, wenn überhaupt, nur einen unwesentlichen Abfall der Lichtechtheit von einer halben Stufe (8-stufige Blauskala, Prüfung nach DIN 12040) gegenüber der nadelförmigen Kristallform gemäß EP-A-0 010 273.

Gegenstand der Erfindung ist ein C.I. Pigment Yellow 181 der Formel (I) 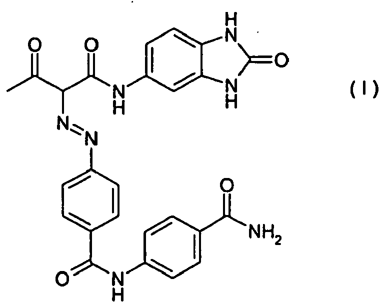 in der beta-Kristallphase,
gekennzeichnet durch eine mittlere Teilchengröße d₅₀ von 80 bis 120 nm, vorzugsweise 90 bis 110 nm, ein Länge-Breite-Verhältnis von kleiner oder gleich 2:1, vorzugsweise kleiner oder gleich 1,8 : 1.

Es wurde gefunden, dass überraschenderweise nur eine Salzknetung mit anorganischen Salzen in Gegenwart eines organischen Lösemittels zu den erfindungsgemäßen Pigmenten führt, während durch andere Zerkleinerungsmethoden, wie z.B. Trockenmahlungen und Mahlungen in Suspension, nur Pigmente erhalten werden, die einen beträchtlichen Anteil nadelförmiger Kristalle mit einem Länge-Breite-Verhältnis größer als 3:1 aufweisen. Überraschend ist dabei ferner, dass bei dem Einsatz jeder der in WO-A-2006/005 408 beschriebenen Kristallphase alpha, beta, gamma, delta, epsilon, zeta, eta, theta, iota oder kappa als Ausgangsmaterial ein erfindungsgemäßes C.I. Pigment Yellow 181 erhalten wird, wenn man die besagte Salzknetung durchführt.

Gegenstand der Erfindung ist daher auch ein Verfahren zur Herstellung des erfindungsgemäßen C.I. Pigment Yellow 181, gekennzeichnet durch die Verknetung einer beliebigen Kristallphase von C.I. Pigment Yellow 181 mit einem kristallinen anorganischen Salz in Gegenwart eines organischen Lösemittels.

Als anorganisches Salz werden vorzugsweise Alkali- oder Erdalkalihalogenide, Alkali- oder Erdalkalicarbonate, Alkali- oder Erdalkalisulfate, Aluminiumsulfat oder eine Kombination davon eingesetzt. Besonders bevorzugt sind Natrium- oder Kaliumhalogenide. Ganz besonders bevorzugt sind Natrium- oder Kaliumchlorid. Vorzugsweise wird die Verknetung bei 30 bis 150°C für 0,1 bis 100 h durchgeführt. Besonders bevorzugt ist eine Knetung bei 60 bis 130°C für 1 bis 48 h.

Das Verhältnis von anorganischem Salz zu C.I. Pigment Yellow 181 kann in weiten Bereichen variiert werden. Bevorzugt ist ein Pigment-Salz-Verhältnis von 1:3 bis 1:20, besonders bevorzugt 1:5 bis 1:8.

Das Gewichtsverhältnis zwischen dem organischen Lösemittel und dem anorganischem Salz beträgt bevorzugt 1 ml : 6 g bis 3 ml : 7 g.

Das Gewichtsverhältnis zwischen dem organischen Lösemittel und der Summe aus anorganischem Salz und Pigment beträgt bevorzugt 1 ml : 2,5 g bis 1 ml : 7,5 g.

Das organische Lösemittel kann mit Wasser mischbar oder nicht mischbar sein. Als organische Lösemittel kommen Alkohole mit 1 bis 10 C-Atomen, wie beispielsweise Methanol, Ethanol, n-Propanol, Isopropanol, Butanole, wie n-Butanol, iso-Butanol, tert.-Butanol, Pentanole, wie n-Pentanol, 2-Methyl-2-butanol, Hexanole, wie 2-Methyl-2-pentanol, 3-Methyl-3-pentanol, 2-Methyl-2-hexanol, 3-Ethyl-3-pentanol, Octanol, wie 2,4,4-Trimethyl-2-pentanol, Cyclohexanol ; oder Glykole, wie Ethylenglykol, Diethylenglykol, Propylenglykol, Dipropylenglykol, oder Glycerin ; Polyglykole, wie Polyethylen- oder Polypropylenglykole ; Ether, wie Methylisobutylether, Tetrahydrofuran, Dimethoxyethan oder Dioxan ; Glykolether, wie Monomethyl- oder Monoethylether des Ethylen- oder Propylenglykols, Diethylenglykol-monomethylether, Diethylenglykol-monoethylether, Butylglykole oder Methoxybutanol; Ketone, wie Aceton, Diethylketon, Methylisobutylketon, Methylethylketon oder Cyclohexanon ; aliphatische Säureamide, wie Formamid, Dimethylformamid, N-Methylacetamid oder N,N-Dimethytacetamid; Harnstoffderivate, wie Tetramethylharnstoff; oder acyclische Carbonsäureamide, wie N-Methylpyrrolidon, Valero- oder Caprolactam; Ester, wie Carbonsäure-C₁-C₆-alkylester, wie Ameisensäurebutylester, Essigsäureethylester oder Propionsäurepropylester; oder Carbonsäure-C₁-C₆-glykolester; oder Glykoletheracetate, wie 1-Methoxy-2-propylacetat; oder Phthalsäure- oder Benzoesäure-C₁-C₆-alkylester, wie Benzoesäureethylester; cyclische Ester, wie Caprolacton ; Nitrile, wie Acetonitril oder Benzonitril; aliphatische oder aromatische Kohlenwasserstoffe, wie Cyclohexan oder Benzol; oder durch Alkyl, Alkoxy, Nitro oder Halogen substituiertes Benzol, wie Toluol, Xylole, Ethylbenzol, Anisol, Nitrobenzol, Chlorbenzol, o-Dichlorbenzol, 1,2,4-Trichlorbenzol oder Brombenzol; oder andere substituierte Aromaten, wie Benzoesäure oder Phenol; aromatische Heterocyclen, wie Morpholin, Picolin oder Chinolin; sowie Hexamethylphosphorsäuretriamid, 1,3-Dimetyl-2-imidazolidinon, Dimethylsulfoxid und Sulfolan in Betracht.

Besonders bevorzugt sind Glykole.

Bei der Auswahl der Lösemittel ist darauf zu achten, dass sie unter den gewählten Bedingungen stabil sind.

Nach Abschluss der Salzknetung werden die anorganischen Salze in Wasser gelöst, gegebenenfalls in Anwesenheit einer Säure oder Lauge. Das Pigment wird in üblicher Weise durch Filtration isoliert. Vor einer Isolation des Pigments kann das Lösemittel destillativ, gegebenenfalls unter reduziertem Druck, oder auch durch Wasserdampfdestillation entfernt werden.

Das eingesetzte Rohpigment C.I. Pigment Yellow 181 kann in jeder der in WO-A-2006/005 408 beschriebenen Kristallphase alpha, beta, gamma, delta, epsilon, zeta, eta, theta, iota oder kappa eingesetzt werden.

Das nach der Knetung isolierte feinteilige C.I. Pigment Yellow 181 kann nach Filtration als Filterkuchen oder als getrocknetes Material gegebenenfalls einer Lösungsmittelnachbehandlung unterzogen werden, um eine homogenere Teilchenform zu erhalten, ohne die Teilchengröße merklich zu erhöhen. Bevorzugt ist die Verwendung von Wasser oder wasserdampfflüchtigen Lösungsmitteln wie Alkoholen und aromatischen Lösungsmitteln, besonders bevorzugt verzweigte oder unverzweigte C₁-C₆Alkohole, Toluol, Xylol, Chlorbenzol, Dichlorbenzol, Nitrotoluol oder Nitrobenzol meist unter erhöhter Temperatur, beispielsweise bis 200°C, und gegebenenfalls unter erhöhtem Druck.

Bei der Trocknung eines feuchten Pigments können die bekannten Trockenaggregate zum Einsatz kommen, wie Trockenschränke, Schaufelradtrockner, Taumeltrockner, Kontakttrockner und insbesondere Spinflash- und Sprühtrockner.

Das erfindungsgemäße Pigment kann mit weiteren üblichen Hilfsmitteln und Zusatzstoffen versehen werden, wie beispielsweise Tenside, nichtpigmentäre oder pigmentäre Dispergiermittel, Füllstoffe, Stellmittel, Harze, Wachse, Entschäumer, Antistaubmittel, Extender, Antistatika, Konservierungsmittel, Antioxidantien, Trocknungsverzögerungsmittel, Netzmittel, UV-Absorber und Lichtstabilisatoren, vorzugsweise in einer Menge von 0,1 bis 10 Gew.-%, insbesondere 0,5 bis 5 Gew.-%, bezogen auf das Gesamtgewicht des Pigmentes und der besagten Hilfsmittel und Zusatzstoffe.

Als Tenside kommen anionische oder anionaktive, kationische oder kationaktive und nichtionische oder amphotere Substanzen oder Mischungen dieser Mittel in Betracht.

Als anionaktive Substanzen kommen beispielsweise Fettsäuretauride, FettsäureN-methyltauride, Fettsäureisethionate, Alkylphenylsulfonate, beispielsweise Dodecylbenzolsulfonsäure, Alkylnaphthalinsulfonate, Alkylphenolpolyglykolethersulfate, Fettalkoholpolyglykolethersulfate, Fettsäureamid-polyglykolethersulfate, Alkylsulfosuccinamate, Alkenylbernsteinsäurehalbester, Fettalkoholpolyglykol-ethersulfosuccinate, Alkansulfonate, Fettsäureglutamate, Alkylsulfosuccinate, Fettsäuresarkoside; Fettsäuren, beispielsweise Palmitin-, Stearin- und Ölsäure; die Salze dieser anionischen Substanzen und Seifen, beispielsweise Alkalisalze von Fettsäuren, Naphthensäuren und Harzsäuren, beispielsweise Abietinsäure, alkalilösliche Harze, beispielsweise kolophoniummodifizierte Maleinatharze und Kondensationsprodukte auf Basis von Cyanurchlorid, Taurin, N,N'-Diethylaminopropylamin und p-Phenylendiamin in Betracht. Bevorzugt sind Harzseifen, d.h. Alkalisalze von Harzsäuren.

Als kationaktive Substanzen kommen beispielsweise quaternäre Ammoniumsalze, Fettaminoxalkylate, Polyoxyalkylenamine, oxalkylierte Polyamine, Fettaminpolyglykolether, primäre, sekundäre oder tertiäre Amine, beispielsweise Alkyl-, Cycloalkyl oder cyclisierte Alkylamine, insbesondere Fettamine, von Fettaminen oder Fettalkoholen abgeleitete Di- und Polyamine und deren Oxalkylate, von Fettsäuren abgeleitete Imidazoline, Polyaminoamido- oder Polyaminoverbindungen oder -harze mit einem Aminindex zwischen 100 und 800 mg KOH pro g der Polyaminoamido- oder Polyaminoverbindung, und Salze dieser kationenaktiven Substanzen, wie beispielsweise Acetate oder Chloride, in Betracht.

Als nichtionogene und amphotere Substanzen kommen beispielsweise Fettamincarboxyglycinate, Aminoxide, Fettalkoholpolyglykolether, Fettsäurepolyglykolester, Betaine, wie Fettsäureamid-N-propyl-betaine, Phosphorsäureester von aliphatischen und aromatischen Alkoholen, Fettalkoholen oder Fettalkoholpolyglykolethern, Fettsäureamidethoxylate, Fettalkohol-alkylenoxid-Addukte und Alkylphenolpolyglykolether in Betracht.

Mit nichtpigmentären Dispergiermitteln sind vorzugsweise Substanzen gemeint, die strukturell nicht von organischen Pigmenten abgeleitet sind. Sie werden als Dispergiermittel entweder bereits bei der Herstellung von Pigmenten, oft aber auch bei der Einarbeitung der Pigmente in die zu färbenden Anwendungsmedien, beispielsweise bei der Herstellung von Colorfiltem durch Dispergierung der Pigmente in den entsprechenden Bindemitteln, zugegeben. Es können polymere Substanzen sein, beispielsweise Polyolefine, Polyester, Polyether, Polyamide, Polyimine, Polyacrylate, Polyisocyanate, Blockcopolymere daraus, Copolymere aus den entsprechenden Monomeren oder Polymere einer Klasse, die mit wenigen Monomeren einer anderen Klasse modifiziert sind. Diese polymeren Substanzen tragen polare Ankergruppen wie beispielsweise Hydroxy-, Amino-, Imino- und Ammoniumgruppen, Carbonsäure- und Carboxylatgruppen, Sulfonsäure- und Sulfonatgruppen oder Phosphonsäure- und Phosphonatgruppen, und können auch mit aromatischen, nicht pigmentären Substanzen modifiziert sein. Dispergiermittel können des Weiteren auch chemisch mit funktionellen Gruppen modifizierte aromatische Substanzen sein. Derartige Dispergiermittel sind dem Fachmann bekannt und zum Teil im Handel erhältlich (z.B. Solsperse^{®}, Avecia; Disperbyk^{®}, Byk-Chemie, Efka^{®}, Efka). Es sollen im Folgenden stellvertretend einige Typen genannt werden, zum Einsatz können jedoch prinzipiell beliebige andere, beschriebene Substanzen kommen, beispielsweise Kondensationsprodukte aus Isocyanaten und Alkoholen, Di- oder Polyolen, Aminoalkoholen oder Di- oder Polyaminen, Polymere aus Hydroxycarbonsäuren, Copolymere aus Olefinmonomeren oder Vinylmonomeren und ethylenisch ungesättigten Carbonsäuren und -estern, urethanhaltige Polymere von ethylenisch ungesättigten Monomeren, urethanmodifizierte Polyester, Kondensationsprodukte auf Basis von Cyanurhalogeniden, Nitroxylverbindungen enthaltende Polymere, Polyesteramide, modifizierte Polyamide, modifizierte Acrylpolymere, Dispergiermittel mit kammartiger Struktur aus Polyestern und Acrylpolymeren, Phosphorsäureester, von Triazin abgeleitete Polymere, modifizierte Polyether, oder von aromatischen Substanzen abgeleitete Dispergiermittel. Dabei werden diese Grundstrukturen vielfach weiter modifiziert, beispielsweise durch chemische Umsetzung mit weiteren, funktionelle Gruppen tragenden Substanzen oder durch Salzbildung.

Mit pigmentären Dispergiermitteln sind Pigmentdispergatoren gemeint, die sich von einem organischen Pigment als Grundkörper ableiten und durch chemische Modifizierung dieses Grundkörpers hergestellt werden, beispielsweise saccharinhaltige Pigmentdispergatoren, piperidylhaltige Pigmentdispergatoren, von Naphthalin oder Perylen abgeleitete Pigmentdispergatoren, Pigmentdispergatoren mit funktionellen Gruppen, die über eine Methylengruppe mit dem Pigmentgrundkörper verknüpft sind, mit Polymeren chemisch modifizierte Pigmentgrundkörper, Sulfosäure-, Sulfonamid- oder Sulfosäureestergruppenhattige Pigmentdispergatoren, Ether- oder Thioethergruppenhaltige Pigmentdispergatoren, oder Carbonsäure-, Carbonsäureester- oder Carbonamidgruppenhaltige Pigmentdispergatoren. Anionische Gruppen der als Hilfsmittel eingesetzten nichtpigmentären und pigmentären Dispergatoren, Tenside oder Harze können auch verlackt werden, beispielsweise durch Ca-, Mg-, Ba-, Sr-, Mn- oder Al-Ionen oder durch quaternäre Ammoniumionen.

Mit Füllstoffen bzw. Extendern sind eine Vielzahl von Substanzen gemäß DIN 55943 und DIN EN 971-1 gemeint, beispielsweise die verschiedenen Typen von Talk, Kaolin, Glimmer, Dolomit, Kalk, Bariumsulfat oder Titandioxid. Dabei hat sich die Zugabe besonders vor der Pulverisierung des getrockneten Pigments bewährt.

Das erfindungsgemäße C.I. Pigment Yellow 181 eignet sich allein oder in Mischungen, die das erfindungsgemäße Pigment enthalten, zum Pigmentieren von hochmolekularen organischen Materialien natürlicher oder synthetischer Herkunft, z.B. von Lacken, Kunststoffen, Harzen, Anstrichfarben, Druckfarben, Pigmentpräparationen, insbesondere wässrigen oder lösemittelhaltigen Pigmentpräparationen, elektrophotographischen Tonern und Entwicklern, Tinten, Ink-Jet-Tinten, Farbfiltern und electronic inks, und zum Einfärben von Saatgut. Das erfindungsgemäße, feinteilige C.I. Pigment Yellow 181 eignet sich insbesondere zum Einfärben von Colorfiltern, Druckfarben für Dekordrucke und Ink-Jet-Tinten, sowie allen hochtransparenten Lacken und Folien für elektronische Anwendungsfelder.

Unter elektrophotographischen Tonern und Entwicklern werden Ein- oder Zweikomponentenpulvertonem (auch Ein- oder Zweikomponenten-Entwickler genannt), Magnettoner, Flüssigtoner, Latextoner, Polymerisationstoner sowie Spezialtoner verstanden, die dem Fachmann allgemein bekannt sind. Typische Tonerbindemittel sind Polymerisations-, Polyadditions- und Polykondensationsharze, wie Styrol-, Styrolacrylat-, Styrolbutadien-, Acrylat-, Polyester-, Phenol-Epoxidharze, Polysulfone, Polyurethane, einzeln oder in Kombination, sowie Polyethylen und Polypropylen, die noch weitere Inhaltsstoffe, wie Ladungssteuermittel, Wachse oder Fließhilfsmittel, enthalten können oder im Nachhinein mit diesen Zusätzen modifiziert werden.

Unter Ink-Jet Tinten werden solche auf wässriger oder nichtwässriger Basis, Mikroemulsionstinten sowie Tinten, die nach dem hot-melt-Verfahren arbeiten, verstanden, die dem Fachmann allgemein bekannt sind.

In den nachfolgenden Beispielen bedeuten Prozente Gewichtsprozente.

Für die Teilchengrößenverteilung wird eine Serie elektronenmikroskopischer Aufnahmen verwendet. Die Primärteilchen werden visuell identifiziert. Die Fläche der Primärteilchen wird mit Hilfe eines graphischen Tabletts bestimmt. Aus der Fläche wird der Durchmesser des flächengleichen Kreises ermittelt. Die

Häufigkeitsverteilung der so berechneten Äquivalentdurchmesser wird bestimmt, die Häufigkeiten in Volumenanteile umgerechnet und als Teilchengrößenverteilung dargestellt.

### Beispiel 1

80 g C.I. Pigment Yellow 181 in der beta-Phase, hergestellt analog zu Beispiel 1 der EP-A- 0 010 273, mit einer Teilchengröße (d₅₀) von 268 nm werden mit 450 g micronisiertem Natriumchlorid und 140 ml Diethylenglykol 4 Stunden bei 80°C in einem Kneter mit Sigma-Schaufeln geknetet. Die Knetmasse wird in 8 Liter 5 %iger Salzsäure 2 Stunden bei 40°C gerührt, die Suspension wird abgesaugt, der Presskuchen mit Wasser salzfrei gewaschen und bei 80°C getrocknet: Das erhaltene Granulat wird pulverisiert. Es werden 75 g C.I. Pigment Yellow 181 in der beta-Kristallmodifikation mit einer Teilchengröße (d₅₀) von 105 nm und einem Länge-Breite-Verhältnis von 1,56:1 erhalten (s. Abb. 2).

### Beispiel 2

80 g C.I. Pigment Yellow 181 in der alpha-Phase mit einer Teilchengröße (d₅₀) von kleiner 50 nm werden mit 450 g micronisiertem Natriumchlorid und 140 ml Diethylenglykol 4 Stunden bei 80°C in einem Kneter mit Sigma-Schaufeln geknetet. Die Knetmasse wird in 8 Liter 5 gew.-%iger Salzsäure 2 Stunden bei 40°C gerührt, die Suspension wird abgesaugt, der Presskuchen mit Wasser salzfrei gewaschen und bei 80°C getrocknet: Das erhaltene Granulat wird pulverisiert. Es werden 75 g C.I. Pigment Yellow 181 in der reinen beta-Kristallmodifikation mit einer Teilchengröße (d₅₀) von 103 nm und einem Länge-Breite-Verhältnis von 1,46:1 erhalten.

### Beispiel 3

80 g C.I. Pigment Yellow 181 in der alpha-Phase mit einer Teilchengröße (d₅₀) von kleiner 50 nm werden mit 400 g micronisiertem Natriumchlorid und 140 ml Diethylenglykol 8 Stunden bei 100°C in einem Kneter mit Sigma-Schaufeln geknetet.

Die Knetmasse wird in 8 Liter 5 gew.-%iger Salzsäure 2 Stunden bei 40°C gerührt, die Suspension wird abgesaugt, der Presskuchen mit Wasser salzfrei gewaschen und bei 80°C getrocknet. Das erhaltene Granulat wird pulverisiert. Es werden 76 g C.I. Pigment Yellow 181 in der reinen beta-Kristallmodifikation mit einer Teilchengröße (d₅₀) von 106 nm und einem Länge-Breite-Verhältnis von 1,50:1 erhalten.

### Beispiele 4 bis 11

Analog zu Beispiel 1 wurden C.I. Pigment Yellow 181 in der gamma, delta, epsilon, zeta, eta, theta, iota und kappa Kristallphase geknetet.

| Beispiel | Phase des Ausgangsmaterials | Phase des Produktes | Länge/Breite-Verhältnis |
|---|---|---|---|
| 4 | gamma | beta | < 1,8 : 1 |
| 5 | delta | beta | < 1,8 : 1 |
| 6 | epsilon | beta | < 1,8 : 1 |
| 7 | zeta | beta | < 1,8 : 1 |
| 8 | eta | beta | < 1,8 : 1 |
| 9 | theta | beta | < 1,8 : 1 |
| 10 | iota | beta | < 1,8 : 1 |
| 11 | kappa | beta | < 1,8 : 1 |

### Anwendungsbeispiele

Das Pigment wird 10%ig in einem Tiefdruckfirnis durch Schütteln mit Glaskugeln dispergiert und anschließend mit Tiefdruckfirnis auf 3 % Pigmentgehalt reduziert. Die erhaltenen Farben werden mit einem Rakelstab (12 µm Nassfilmstärke) auf Dekordruckpapier appliziert (Drawdown). Zur Prüfung der Echtheiten werden die Drawdowns nach 24h Trocknung (bei 50°C) und Vorkondensation (mit Melaminharz als 55proz. Lösung in Wasser, Trocknung 2 min bei 120°C) mit Phenolkernpapieren bei 150°C / 80 bar / 10 min. zu einem Laminat verpresst. Die Bewertung der Transparenz erfolgt visuell an der 10proz. Farbe und wird in einer Skala von 0-6 (0-genau gleich, 6-deutlich transparenter angegeben. Die Bewertung der Lichtechtheit erfolgt nach DIN ISO 12040 (Xenon, 1200W, Gleichlauf) an 10 %igen und 3 %igen laminierten Drawdowns ohne Angleich der Farbstärke gegen die 8-stufige Woll-Skala.

Die Farbstärke wird an der 3 prozentiger Farbe bestimmt. Die Bewertung erfolgt jeweils gegenüber einem Pigment, das nach EP-A-0 010 273, Beispiel 1 gewonnen wurde:

| | Lichtechtheit | | Farbstärke | Transparenz |
|---|---|---|---|---|
| Pigmentkonzentration | 10% | 3% | | |
| EP-A-0010273, Bsp.1 | 7 | 6-7 | 100 % | - |
| Beispiel 1 | 6-7 | 6 | 140 % | 6 transparenter |
| Beispiel 2 | 6-7 | 6 | 140 % | 6 transparenter |
| Beispiel 3 | 6-7 | 6 | 135 % | 6 transparenter |

## Patentansprüche

1. C.I. Pigment Yellow 181 der Formel (I), 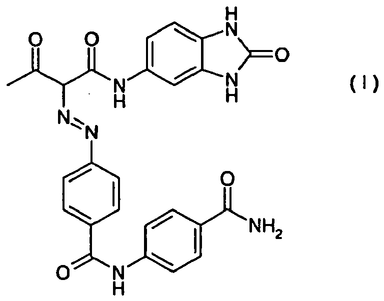 in der beta-Kristallphase, **gekennzeichnet durch** eine mittlere Teilchengröße d₅₀ von 80 bis 120 nm und **durch** ein Länge-Breite-Verhältnis von kleiner oder gleich 2:1.

2. C.I. Pigment Yellow 181 nach Anspruch 1, **gekennzeichnet durch** eine mittlere Teilchengröße d₅₀ von 90 bis 110 nm.

3. C.I. Pigment Yellow 181 nach Anspruch 1 oder 2, **gekennzeichnet durch** ein Länge-Breite-Verhältnis d₅₀ von kleiner oder gleich 1,8:1.

4. Verfahren zur Herstellung von C.I. Pigment Yellow 181 nach einem oder mehreren der Ansprüche 1 bis 3, **gekennzeichnet durch** die Verknetung einer beliebigen Kristallphase alpha, beta, gamma, delta, epsilon, zeta, eta, theta, iota oder kappa von C.I. Pigment Yellow 181 mit einem kristallinen anorganischen Salz in Gegenwart eines organischen Lösemittels.

5. Verfahren nach Anspruch 4, **dadurch gekennzeichnet, dass** das kristalline anorganische Salz ein Alkali- oder Erdalkalihalogenid, ein Alkali- oder Erdalkalicarbonat, ein Alkali- oder Erdalkalisulfat, Aluminiumsulfat oder eine Kombination davon ist.

6. Verfahren nach Anspruch 4 oder 5, **dadurch gekennzeichnet, dass** das organische Lösemittel ein Glykol ist.

7. Verfahren nach einem oder mehreren der Ansprüche 4 bis 6, **dadurch gekennzeichnet, dass** nach der Verknetung und Isolierung eine Lösemittelbehandlung in Wasser oder wasserdampfflüchtigen Lösemitteln durchgeführt wird.

8. Verwendung von C.I. Pigment Yellow 181 nach einem oder mehreren der Ansprüche 1 bis 3 zum Pigmentieren von hochmolekularen organischen Materialien natürlicher oder synthetischer Herkunft.

9. Verwendung nach Anspruch 8 zum Pigmentieren von Druckfarben und von Folien für elektronische Anwendungen.

10. Verwendung nach Anspruch 9 zum Pigmentieren von Colorfiltern und Ink-Jet-Tinten.

11. Verwendung nach Anspruch 9 zum Pigmentieren von elektrophotographischen Tonern und Entwicklern.

## Claims

1. C.I. Pigment Yellow 181 of formula (I), 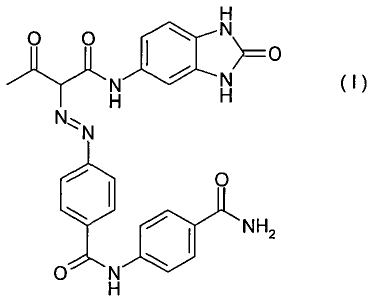 in the beta crystal phase, **characterized by** a median particle size d₅₀ of 80 to 120 nm and by a length/width ratio of not more than 2:1.

2. C.I. Pigment Yellow 181 according to Claim 1, **characterized by** a median particle size d₅₀ of 90 to 110 nm.

3. C.I. Pigment Yellow 181 according to Claim 1 or 2, **characterized by** a length/width ratio of not more than 1.8:1.

4. Process for production of C.I. Pigment Yellow 181 according to one or more of Claims 1 to 3, **characterized by** the kneading of any desired crystal phase alpha, beta, gamma, delta, epsilon, zeta, eta, theta, iota or kappa of C.I. Pigment Yellow 181 with a crystalline inorganic salt in the presence of an organic solvent.

5. Process according to Claim 4, **characterized in that** the crystalline inorganic salt is an alkali or alkaline earth metal halide, an alkali or alkaline earth metal carbonate, an alkali or alkaline earth metal sulfate, aluminum sulfate or a combination thereof.

6. Process according to Claim 4 or 5, **characterized in that** the organic solvent is a glycol.

7. Process according to one or more of Claims 4 to 6, **characterized in that** a solvent treatment in water or solvents that are water vapor volatile is carried out after the kneading and isolating.

8. Use of C.I. Pigment Yellow 181 according to one or more of Claims 1 to 3 for pigmentation of macromolecular organic materials of natural or synthetic origin.

9. Use according to Claim 8 for pigmentation of printing inks and of films for electronic applications.

10. Use according to Claim 9 for pigmentation of color filters and ink-jet inks.

11. Use according to Claim 9 for pigmentation of electrophotographic toners and developers.

## Revendications

1. Pigment C.I. Jaune 181 de la formule (I), 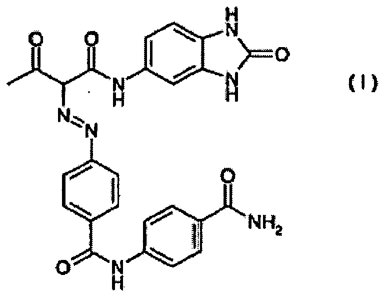 dans la phase de cristal β, **caractérisé par** une taille moyenne de particules d₅₀ de 80 à 120 nm et par un rapport longueur-largeur inférieur ou égal à 2:1.

2. Pigment C.I. Jaune 181 selon la revendication 1, **caractérisé par** une taille moyenne de particules d₅₀ de 90 à 110 nm.

3. Pigment C.I. Jaune 181 selon la revendication 1 ou 2, **caractérisé par** un rapport longueur-largeur inférieur ou égal à 1,8:1.

4. Procédé de fabrication de pigment C.I. Jaune 181 selon une ou plusieurs des revendications 1 à 3, **caractérisé par** le malaxage d'une phase cristalline quelconque alpha, bêta, gamma, delta, epsilon, zêta, êta, thêta, iota ou kappa de pigment C.I. Jaune 181 avec un sel inorganique cristallin en présence d'un solvant organique.

5. Procédé selon la revendication 4, **caractérisé en ce que** le sel inorganique cristallin est un halogénure alcalin ou alcalino-terreux, un carbonate alcalin ou alcalino-terreux, un sulfate alcalin ou alcalino-terreux, le sulfate d'aluminium ou une combinaison de ceux-ci.

6. Procédé selon la revendication 4 ou 5, **caractérisé en ce que** le solvant organique est un glycol.

7. Procédé selon une ou plusieurs des revendications 4 à 6, **caractérisé en ce que** l'on effectue, après le malaxage et l'isolement, un traitement au solvant dans l'eau ou des solvants pouvant être entraînés à la vapeur d'eau.

8. Utilisation de pigment C.I. Jaune 181 selon une ou plusieurs des revendications 1 à 3, pour la pigmentation de matières organiques à haut poids moléculaire d'origine naturelle ou synthétique.

9. Utilisation selon la revendication 8 pour la pigmentation d'encres d'imprimerie et de films pour des applications électroniques.

10. Utilisation selon la revendication 9 pour la pigmentation de filtres de couleurs et d'encres d'impression à jet d'encre.

11. Utilisation selon la revendication 9 pour la pigmentation de toners et de révélateurs électrophotographiques.
